# EUROPÄISCHE PATENTANMELDUNG

(11) **EP 1 703 562 A1**
(43) Veröffentlichungstag der Anmeldung: **20.09.2006**
(21) Anmeldenummer: 05102099.8
(22) Anmeldetag: 17.03.2005
(51) Int. Cl.: H01L 27/146, H01L 31/0216

(54) **Optischer Empfänger mit einer dem menschlichen Auge nachempfundenen spektralen Empfindlichkeit**

(71) Anmelder: ELMOS Semiconductor AG, 44227 Dortmund (DE)
(72) Erfinder: Budde, Wolfram, 46487 Wesel (DE)
(74) Vertreter: Hilleringmann, Jochen

(57) **Zusammenfassung**

Der optischer Empfänger mit einer dem menschlichen Auge nachempfundenen spektralen Empfindlichkeitscharakteristik ist versehen mit einer ersten Photodiode (10) mit einer spektralen Empfindlichkeit, die im IR-Spektrum größer ist als die des menschlichen Auges, einer zweiten Photodiode (24), deren maximale Empfindlichkeit im IR-Spektrum liegt, und einer Subtrahiereinheit (30) zum Subtrahieren des Photostroms der zweiten Photodiode (24) von dem der ersten Photodiode (10). Die zweite Photodiode (24) weist ein mit Ladungsträgern eines ersten Leitungstyps dotiertes Halbleitersubstrat (12) mit einem aktiven Gebiet (16), das mit Ladungsträgern eines zweiten Leitungstyps dotiert ist, und in dem aktiven Gebiet (16) ein mit Ladungsträgern des ersten Typs dotiertes Gebiet (20) auf. Ferner ist das aktive Gebiet (16) der zweiten Photodiode (24) von einer Abschirmungsschicht (26) aus einem Material überdeckt, das Strahlungsanteile des Umgebungs- oder Sonnenlichts im Infrarot-Bereich bis in das aktive Gebiet (16) und in das Halbleitersubstrat (12) hindurchlässt und in dem sich infolge der Strahlungsanteili des Umgebungs- oder Sonnenlichts im blauen Bereich rekombinierende und damit nicht zum Photostrom der zweiten Photodiode (24) beitragende Elektron-Loch-Paare bilden.

## Beschreibung

Die Erfindung betrifft: einen optischen Empfänger mit einer dem menschlichen Auge nachempfundenen spektralen Empfindlichkeit. Im folgenden wird ferner ein Verfahren zur Herstellung eines Photoempfängers mit der spektralen Empfindlichkeit nahe der des menschlichen Auges in einer Standard-CMOS-Technologie beschrieben. Auch wird im folgenden eine einfache Art der Auswertung der Photoströme zweier Photodioden erläutert.

Die normalerweise in einer Standard-CMOS-Technologie ohne fertigungstechnischen Mehraufwand verfügbaren Photodioden haben ihr Empfindlichkeitsmaximum im Infrarot-Bereich bei ca. 600-700nm und entsprechen daher in ihren Eigenschaften nicht denen des menschlichen Auges, das seine größte Empfindlichkeit nahe bei 550nm hat Für Anwendungen, in denen es darauf ankommt, der Empfindlichkeit des menschlichen Auges möglichst nahe zu kommen (z. B. in Vorrichtungen, um automatisch bei Dämmerung das Fahrlicht einzuschalten oder in Belichtungsmessern von Fotoapparaten), sind diese Photodioden weniger geeignet.

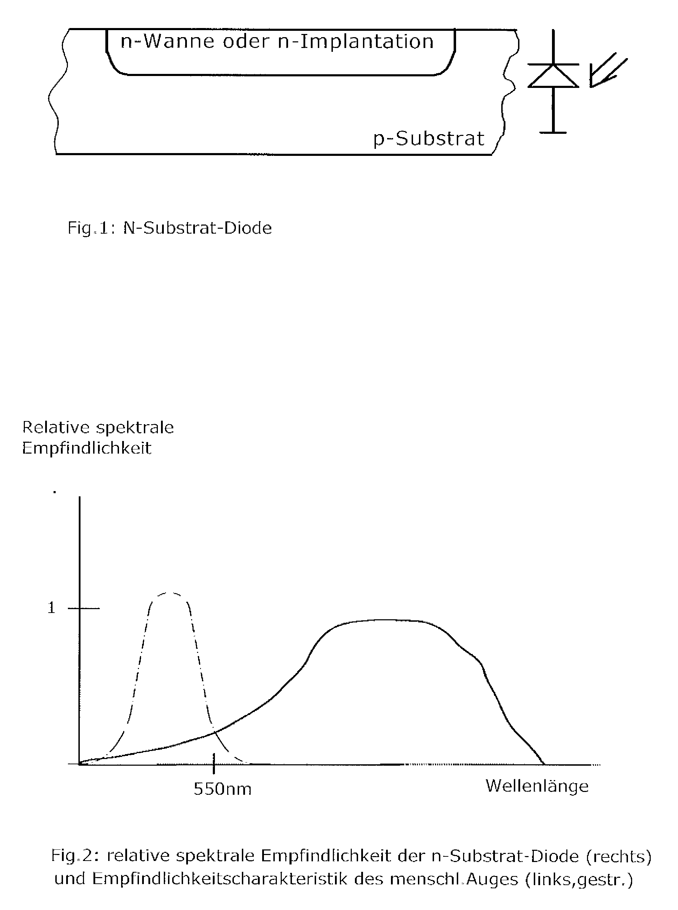

Fig. 1 zeigt eine gängige Variante einer Photodiode in Standard-CMOS-Technologie und Fig. 2 die zugehörige spektrale Empfindlichkeitscharakteristik.

Die Eindringtiefe des sichtbaren Lichtes in das Silizium ist eine Funktion der Wellenlänge. Langwelliges (rotes und infrarotes) Licht dringt tiefer ein und erzeugt Elektron-Loch-Paare relativ tief im Substrat. Sämtliche Elektronen die, bevor sie rekombinieren, eine Raumladungszone erreichen, tragen zum Photostrom bei.

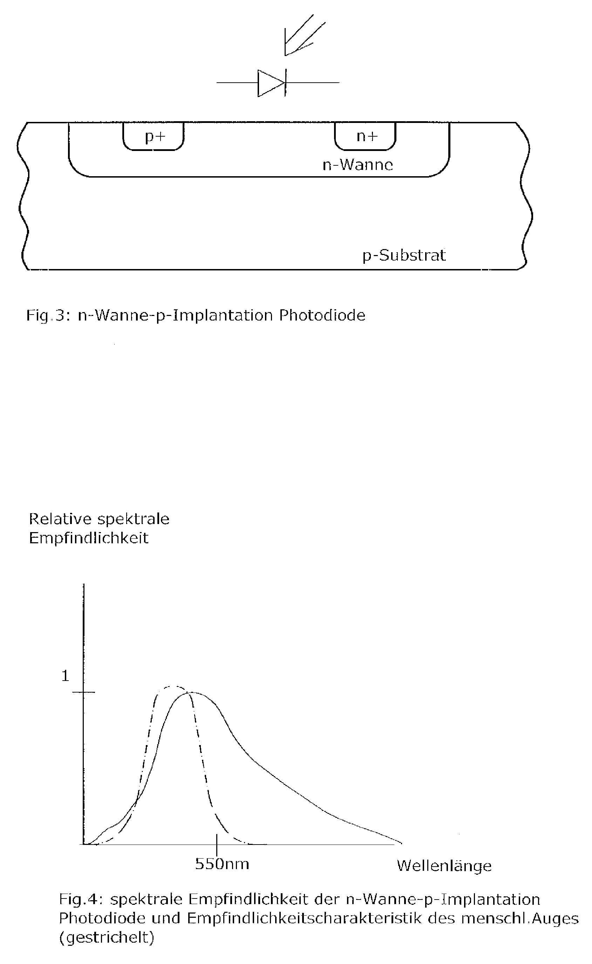

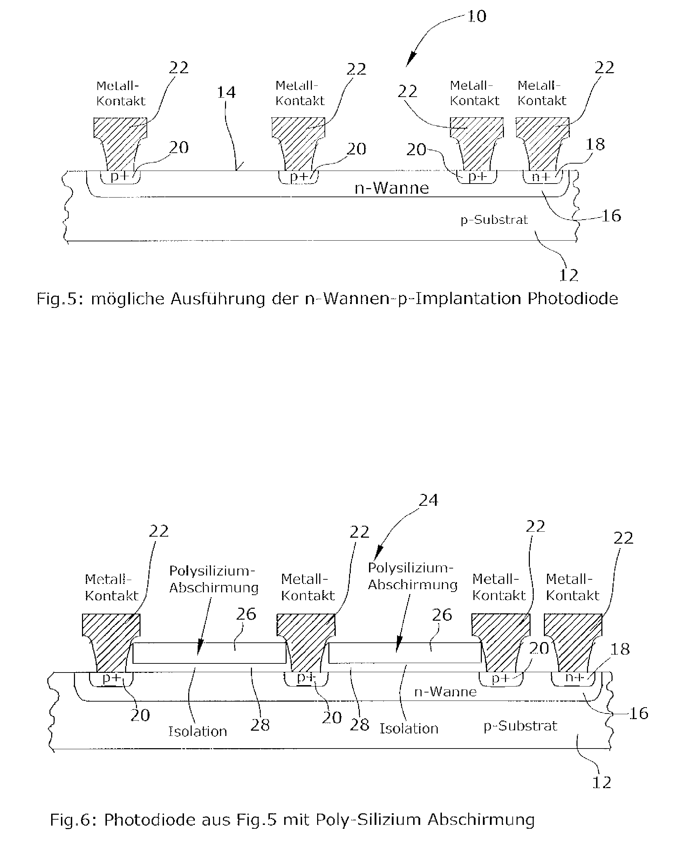

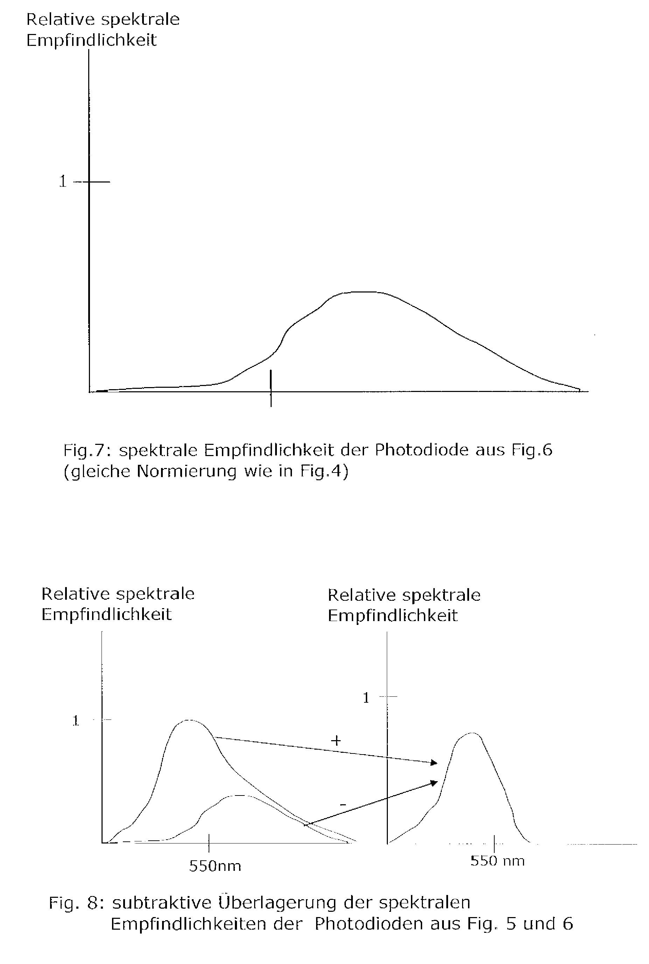

Will man einen mehr ins blaue Spektrum erschobenen Photosensor herstellen, so kann man einen weiteren Photodioden-Typ verwenden. Fig. 3 zeigt eine aus einer n-Wanne und p+-Implantation hergestellte Photodiode. Dieser Photodioden-Typ besitzt eine ins blaue Spektrum verschobene Empfindlichkeitscharakteristik, wie Fig. 4 zeigt.

Ursache für die im Vergleich zu Fig. 2 nach links verschobene Kurve (mit typischerweise auch kleinerer absoluter Effizienz als die in Fig. 1 gezeigte Diode) ist die Tatsache, dass nur in der Wanne generierte Elektron-Loch-Paare zum Photostrom betragen. Da die Wanne sehr dünn ist (einige µm oder weniger als 1µm) trägt hier hauptsächlich das blaue Licht zum Photostrom bei. Das rote (IR-) Licht generiert in erster Linie Ladungsträger unterhalb der Wanne, die nicht zum Diodenstrom beitragen.

Über die Dicke der n-Wanne kann die spektrale Empfindlichkeit variiert werden.

Nachteilig bei der Photodiode ist dennoch, dass der nur langsam abnehmende Infrarot-Anteil noch zu groß ist, um dem des Auges nahe zu kommen.

Wünschenswert wäre eine Möglichkeit, den Infrarot-Anteil zu beseitigen.

Mit externen Filtern oder speziellen Filter- und Farbschichten ist eine Filterung möglich und Stand der Technik. Im folgenden wird eine neue Methode beschrieben, den Infrarot-Anteil mit einer einfachen Modifikation des Aufbaus der Photodiode (Einbringen einer Abschirmung) und Methoden der Schaltungstechnik zu beseitigen.

Aufgabe der Erfindung ist es, einen optischen Empfänger mit einer dem menschlichen Auge nachempfundenen spektralen Empfindlichkeit zu schaffen, wobei der optische Empfänger unter Verwendung von Prozessschritten einer Standard-CMOS-Technologie gefertigt werden kann.

Zur Lösung dieser Aufgabe wird mit der Erfindung ein optischer Empfänger mit einer dem menschlichen Auge nachempfundenen spektralen Empfindlichkeit vorgeschlagen, der versehen ist mit einem optischen Empfänger mit einer dem menschlichen Auge nachempfundenen spektralen Empfindlichkeitscharakteristik, mit
- einer ersten Photodiode mit einer spektralen Empfindlichkeit, die im IR-Spektrum größer ist als die des menschlichen Auges,
- einer zweiten Photodiode, deren maximale Empfindlichkeit im IR-Spektrum liegt,
- und einer Subtrahiereinheit zum Subtrahieren des Photostroms der zweiten Photodiode von dem der ersten Photodiode,
- wobei die zweite Photodiode ein mit Ladungsträgern eines ersten Leitungstyps dotiertes Halbleitersubstrat mit einem aktiven Gebiet, das mit Ladungsträgern eines zweiten Leitungstyps dotiert ist und das an einer Raumladungszone angrenzende erste Gebiet der zweiten Photodiode bildet, und in dem aktiven Gebiet ein mit Ladungsträgern des ersten Typs dotiertes Gebiet aufweist, das das an die Raumladungszone angrenzende zweite Gebiet der zweiten Photodiode bildet, und
- wobei das aktive Gebiet der zweiten Photodiode von einer Abschirmungsschicht aus einem Material überdeckt ist, das Strahlungsanteile des Umgebungs- oder Sonnenlichts im Infrarot-Bereich bis zumindest in das aktive Gebiet hindurchlässt und in dem sich infolge der Strahlungsanteile des Umgebungs- oder Sonnenlichts im blauen Bereich rekombinierende und damit nicht zum Photostrom der zweiten Photodiode beitragende Elektron-Loch-Paare bilden.

Nach der Erfindung werden also zwei Photodioden miteinander kombiniert. Beide Photodioden sind in (Standard-)CMOS-Technologie hergestellt. Die erste Photodiode weist eine spektrale Empfindlichkeit auf, wie sie oben im Zusammenhang mit der Beschreibung der Fign. 3 und 4 erläutert ist. Dies wird durch die Ausbildung einer vergleichsweise flachen (n-)Wanne erreicht, was weiter oben im Einzelnen erläutert ist. Gegenüber der Empfindlichkeit des menschlichen Auges weist die erste Photodiode also eine erhöhte Infrarot-Empfindlichkeit auf. Um dies zu kompensieren, wird eine zweite Photodiode eingesetzt, die ihre maximale Empfindlichkeit im IR-Spektralbereich aufweist. Diese zweite Photodiode ist innerhalb des Bereichs maximaler Empfindlichkeit des menschlichen Auges nur wenig empfindlich. Durch Subtraktion der Empfindlichkeitscharakteristika dieser beiden Photodioden entsteht eine resultierende Empfindlichkeit des erfindungsgemäßen optischen Empfängers, die der des menschlichen Auges hinreichend gut nachempfunden ist.

Die Besonderheit des erfindungsgemäßen optischen Empfängers ist in der Ausbildung der zweiten Photodiode zu sehen. Diese zweite Photodiode gleicht ihrem Aufbau nach der ersten Photodiode. Die zweite Photodiode ist innerhalb eines aktiven Gebiets eines Halbleitersubstrats ausgebildet. Das Halbleitersubstrat ist mit Ladungsträgern eines ersten Leitungstyps dotiert (beispielsweise p-Substrat), wobei in der Oberseite des Halbleitersubstrats ein aktives Gebiet als Wanne mit Ladungsträgern eines zweiten Leitungstyps ausgebildet ist. Dieses aktive Gebiet ist im Falle eines p-Substrats n-dotiert. In dem n-dotierten aktiven Gebiet ist ein mit Ladungsträgern des ersten Typs dotiertes Gebiet eingebracht (p- bzw. p+-Gebiet). Zwischen diesem Gebiet und dem aktiven Gebiet bildet sich die Raumladungszone der Photodiode. Erfindungsgemäß ist das aktive Gebiet überdeckt. Dies erfolgt innerhalb der elektrischen Anschlussbereiche durch die Metallisierung und im übrigen durch eine Abschirmschicht aus einem Material, das Strahlungsanteile des Umgebungs- bzw. Sonnenlichts im Infrarotbereich bis in das Halbleitersubstrat und damit auch bis in das aktive Gebiet hindurchlässt und demgegenüber Strahlungsanteile im blauen Bereich, also unterhalb des Infrarotbereichs abschirmt. Diese Abschirmung erfolgt dabei dergestalt, dass infolge der Eindringung von Umgebungs- oder Sonnenlicht erzeugte Elektron-Loch-Paare in der Abschirmungsschicht rekombinieren und somit nicht zum Photostrom beitragen. Auf diese Weise ist durch einfaches Aufbringen einer Abschirmungsschicht eine Photodiode entstanden, die ihre maximale Empfindlichkeit im Infrarotbereich hat. Diese Empfindlichkeitscharakteristik lässt sich nun von der Empfindlichkeitscharakteristik der ersten vier Diode subtrahieren, um eine Gesamtempfindlichkeitscharakteristik zu erzielen, die die des menschlichen Auges recht gut abbildet.

Vorteilhafterweise weist die Abschirmungsschicht Polysilizium auf, das auf einer Isolationsschicht auf dem aktiven Gebiet ausgebildet ist. Polysilizium hat die Eigenschaften, Strahlungsanteile im blauen Spektrum nicht durchzulassen, indem im Polysilizium erzeugte Elektron-Loch-Paare direkt dort rekombinieren und somit nicht zum Photostrom beitragen, während Strahlungsanteile im Infrarotbereich das Polysilizium passieren können und somit im aktiven Gebiet Elektron-Loch-Paare erzeugen, die dort auch rekombinieren, also den Photostrom bestimmen. Durch die Verwendung von Polysilizium als Material für die Abschirmungsschicht lässt sich der gesamte erfindungsgemäße optische Empfänger nun in Standard-CMOS-Technologie herstellen, was außerordentlich vorteilhaft ist.

Durch Subtraktion der Empfindlichkeitscharakteristika bzw. der Photoströme beider Photodioden ist eine Nachempfindung der spektralen Empfindlichkeit des menschlichen Auges möglich.

Eine einfache Realisierung einer Subtrahiereinheit weist zweckmäßigerweise einen Operationsverstärker auf, an dessen invertierendem Eingang die beiden Photodioden antiparallel verschaltet sind. Hierbei ist es zweckmäßig, wenn die zweite Photodiode mit ihrer Kathode und die erste Photodiode mit ihrer Anode mit dem invertierenden Eingang des Operationsverstärkers verbunden ist.

Die Erfindung wurde vorstehend anhand der Kombination der beiden näher beschriebenen Dioden erläutert. Je nach Anwendungsfall kann es durchaus jedoch ausreichend sein, lediglich eine dieser Dioden zu verwenden. Demzufolge ist die Erfindung auf die Kombination beider Dioden nicht beschränkt. Vielmehr kann jede Diode auch einzeln und damit von der jeweils anderen Diode getrennt Verwendung finden.

Die Erfindung wird nachfolgend anhand der Zeichnung näher erläutert. Im einzelnen zeigen dabei:
- Fig. 1: schematisch den Aufbau einer n-Substrat-Diode, wie sie in einem Standard-CMOS-Prozess herstellbar ist,
- Fig. 2: die relative spektrale Empfindlichkeit der n-Substrat-Diode nach Fig. 1,
- Fig. 3: eine schematische Darstellung einer n-Wanne-p-Implantation-Photodiode mit einer gegenüber der Empfindlichkeitscharakteristiken des menschlichen Auges zum Infrarot hin verschobenen Empfindlichkeitscharakteristik und ebenfalls in Standard-CMOS-Technologie herstellt,
- Fig. 4: die spektrale Empfindlichkeit der Photodiode nach Fig. 3,
- Fig. 5: ein AusfÜhrungsbeispiel für eine erfindungsgemäße Photodiode mit einem n-Gebiet und mehreren p-Gebieten innerhalb eines aktiven Gebiets, ebenfalls hergestellt in einem Standard-CMOS-Prozess,
- Fig. 6: die Photodiode gemäß Fig. 5 mit Polysiliziumabschirmung,
- Fig. 7: die spektrale Empfindlichkeit der Photodiode nach Fig. 6,
- Fig. 8: die subtraktive Überlagerung der spektralen Empfindlichkeiten der Photodioden nach Fign. 5 und 6,
- Fig. 9: eine Prinzipdarstellung zur schaltungstechnischen Realisierung der linearen Auswertung des Photostroms einer Photodiode,
- Fig. 10: ein erstes Ausführungsbeispiel einer erfindungsgemäßen Beschaltung zur subtraktiven Überlagerung der Photoströme der Photodioden nach den Fign. 5 und 6, wenn diese dielektrisch voneinander isoliert sind,
- Fig. 11: ein erstes Ausftihrungsbeispiel einer erfindungsgemäßen Beschaltung zur subtraktiven Überlagerung der Photoströme der Photodioden nach den Fign. 5 und 6, wenn diese dielektrisch nicht voneinander isoliert sind,
- Fig. 12: eine Beschaltung zur additiven Überlagerung dieser Photoströme und
- Fig. 13: die resultierende spektrale Empfindlichkeit bei Verwendung der Schaltung nach Fig. 11.

Nach der Erfindung werden zunächst zwei ähnliche, aber in der spektralen Empfindlichkeit verschiedene Photodioden erzeugt. Die erste ist die schon bekannte n-Wanne-p-Implantation Photodiode. Fig. 5 zeigt eine mögliche Ausführung dieser ersten Photodiode.

Die erste Photodiode 10 weist ein p-Substrat 12 auf, an dessen Oberfläche 14 ein aktives Gebiet in Form einer n-Wanne 16 ausgebildet ist. Innerhalb der n-Wanne 16 sind ein n+-Kontakt 18 und mindestens ein p+-Kontakt 20 ausgebildet. Im hier gezeigten Ausführungsbeispiel sind in der n-Wanne 16 mehrere p+-Kontakte 20 ausgebildet. Der n+-Kontakt 18 bildet die Kathode der Photodiode 10, während die p+-Kontakte 20 zusammen die Anode bilden. Diese oder sämtliche Kontakte sind metallisiert, was bei 22 angedeutet ist. Der Abstand der p+-Kontakte 20 ist kleiner als die freie Weglänge der Elektron-Loch-Paare. Durch die Mehrfachanode kann erreicht werden, dass sich der Gesamtfotostrom aus einer Vielzahl von Teilphotoströmen zusammensetzt.

Die Besonderheit der ersten Photodiode 10 besteht in der relativ flach ausgebildeten n-Wanne 16. Die (langwellige) Infrarotstrahlung aus dem Umgebungs- bzw. Sonnenlicht dringt über die n-Wanne 16 hinaus in das p-Substrat 12 hinein, wo Elektron-Loch-Paare erzeugt werden. Diese Paare erzeugen einen (Foto-)Strom innerhalb des p-Substrats 12, der nicht zum Fotostrom der Photodiode 10 beiträgt, der über die Kathode und die Anode (Anoden) fließt. Auf diese Weise wird die IR-Empfindlichkeit der ersten Photodiode 10 reduziert. Dennoch ist ihre IR-Empfindlichkeit zu groß, als das die Empfindlichkeitscharakteristik der ersten Photodiode 10 als der des menschlichen Auges nachempfunden bezeichnet werden kann.

Erfindungsgemäß wird nun die erste Photodiode 10 mit einer zweiten Photodiode kombiniert.

Fig. 6 zeigt eine Ausfuhrungsform dieser zweiten Photodiode 24, die grundsätzlich wie die erste Photodiode 10 nach Fig. 5 ausgebildet ist, jedoch mit einer Abschirmungsschicht 26 der n-Wanne 16 aus Polysilizium (auf den nichtkontaktierten Bereichen) auf einer Oberflächen-Isolationsschicht 28 (SiO oder SiN) des aktiven Gebiets (n-Wanne 16) versehen ist.

Das Polysilizium dient dazu, den im blauen Spektrum befindlichen Lichtanteil abzuschirmen, das im Infrarot-Bereich befindliche Licht jedoch durchzulassen, Das kurzwellige blaue Licht durchdringt nicht die Polysilizium-Abschirmungsschicht 26, erzeugt also in dieser Abschirmungsschicht 26 Elektron-Loch-Paare, die direkt in dieser Schicht rekombinieren. Da die Polysilizium--Abschirmungsschicht 26 durch die Isolationsschicht 28 elektrisch gegenüber der n-Wanne 16 isoliert ist, tragen die Elektron-Loch-Paare in der Abschirmungsschicht 26 nicht zum Photostrom der zweiten Photodiode 24 bei. Langwellige IR-Strahlung des Umgebungs- bzw. Sonnenlichts gelangt bis in die n-Wanne 16 und über diese hinaus in das p-Substrat 12 hinein. Nur die in der n-Wanne 16 entstehenden Elektron-Loch-Paare tragen zum Photostrom der zweiten Photodiode 24 bei. Fig. 7 zeigt die spektrale Empfindlichkeit der Photodiode 24.

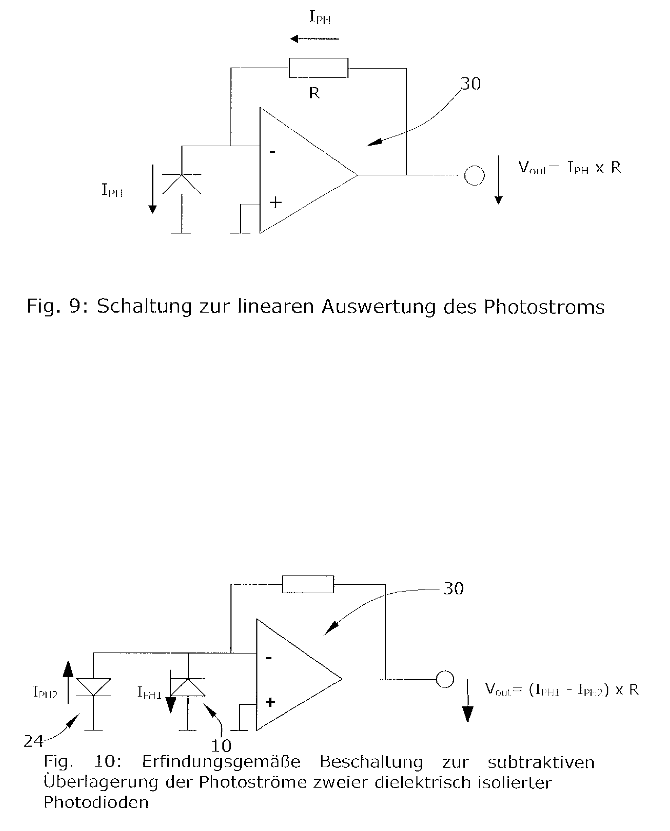

Subtrahiert man die spektralen Empfindlichkeiten (Fig. 8), so erhält man einen Verlauf, der dem des menschlichen Auges nahe kommt. Eine Schaltung, die eine sehr einfache Ausführung der Subtraktion mittels eines Operationsverstärkers 30 als Subtrahiereinheit erlaubt, zeigt Fig. 10.

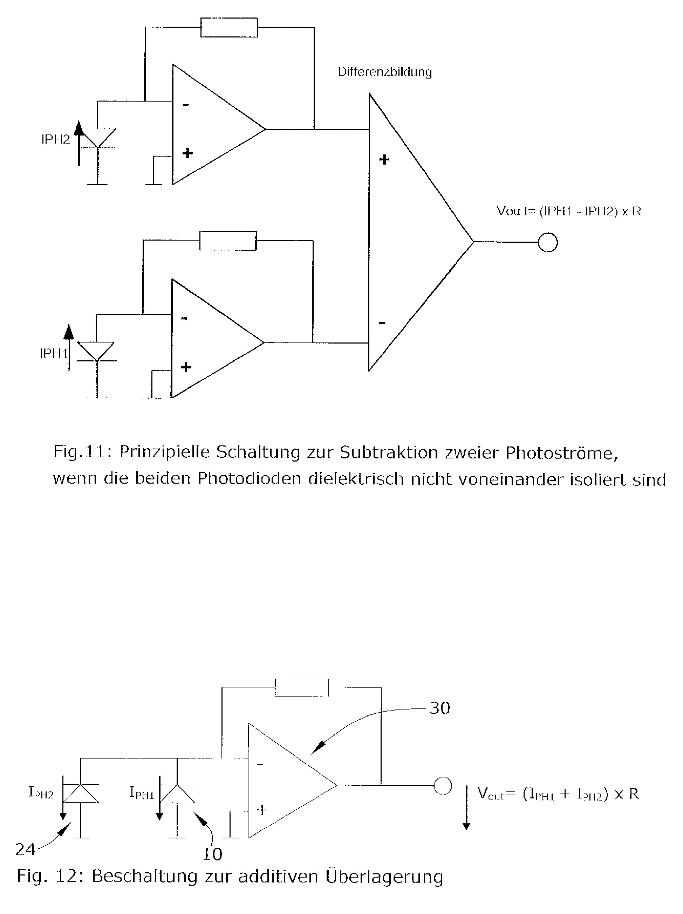

Fig. 9 zeigt das Prinzipschaltbild, wie es heute in vielen Anwendungen verwendet wird. Durch die antiparallele Beschaltung der zwei Photodioden (Fig. 10) am Eingang des Verstärkers erhält man die gewünschte subtraktive Überlagerung. Diese Beschaltung ist für dielektrisch isolierte Dioden die gegebene Variante. Für nicht dielektrisch isolierte Dioden ist eine Subtrahierschaltung erforderlich. Ein Prinzipschaltbild zeigt Fig. 11.

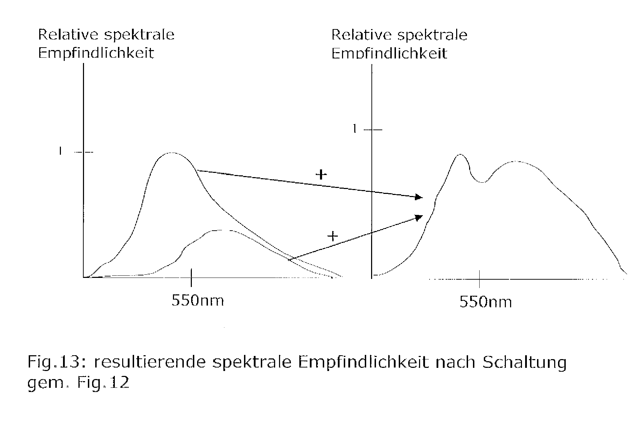

Die Schaltung nach Fig. 10 kann auch modifiziert werden zur additiven Überlagerung. Diese Variante findet sich in Fig. 12.

Fig. 13 zeigt die sich bei Verwendung der Schaltung nach Fig. 12 ergebende resultierende spektrale Empfindlichkeit.

Die Hauptaspekte der Erfindung sind:
1. Verwendung der Polysilizium Abdeckung zur Dämpfung des blauen Anteils des Spektrums und Durchlassen des infraroten Anteils.
2. Verwendung einer weiteren Photodiode ohne Abdeckung.
3. Ausnutzung der auf einem Silizium-Chip vorhandenen gleichen Eigenschaften zur Durchführung der Subtraktion der spektralen Anteile.
4. Die Subtraktion kann in ihren Eigenschaften durch Veränderung der Größe und Abmessung der Photodiode als auch durch Änderung des Layout verändert werden.
5. Verwendung der Beschaltung eines Operationsverstärkers nach Fig. 10 zur Durchführung der Subtraktion.
6. Die Rückkopplung des Operationsverstärkers selbst hat keinen Einfluss auf die Subtraktion und kann auch durch andere Bauelemente wie Kondensatoren, Dioden oder Transistoren ausgeführt sein.
7. Die Subtraktion kann auch durch zwei Operationsverstärker in Instrumentationsverstärker-Konfiguration erfolgen, wobei anstelle der flächenmäßigen Skalierung der Photodiode auch die Verstärkung der beiden Pfade variiert werden kann.

## Patentansprüche

1. Optischer Empfänger mit einer dem menschlichen Auge nachempfundenen spektralen Empfindlichkeitscharakteristik, mit
- einer ersten Photodiode (10) mit einer spektralen Empfindlichkeit, die im IR-Spektrum größer ist als die des menschlichen Auges,
- einer zweiten Photodiode (24), deren maximale Empfindlichkeit im IR-Spektrum liegt,
- und einer Subtrahiereinheit (30) zum Subtrahieren des Photostroms der zweiten Photodiode (24) von dem der ersten Photodiode (10),
- wobei die zweite Photodiode (24) ein mit Ladungsträgern eines ersten Leitungstyps dotiertes Halbleitersubstrat (12) mit einem aktiven Gebiet (16), das mit Ladungsträgern eines zweiten Leitungstyps dotiert ist und das an einer Raumladungszone angrenzende erste Gebiet der zweiten Photodiode (24) bildet, und in dem aktiven Gebiet (16) ein mit Ladungsträgern des ersten Typs dotiertes Gebiet (20) aufweist, das das an die Raumladungszone angrenzende zweite Gebiet der zweiten Photodiode (24) bildet, und
- wobei das aktive Gebiet (16) der zweiten Photodiode (24) von einer Abschirmungsschicht (26) aus einem Material überdeckt ist, das Strahlungsanteile des Umgebungs- oder Sonnenlichts im Infrarot-Bereich bis zumindest in das aktive Gebiet (16) hindurchlässt und in dem sich infolge der Strahlungsanteile des Umgebungs- oder Sonnenlichts im blauen Bereich rekombinierende und damit nicht zum Photostrom der zweiten Photodiode (24) beitragende Elektron-Loch-Paare bilden.

2. Optischer Empfänger nach Anspruch 1, **dadurch gekennzeichnet, dass** das Material der Abschirmungsschicht (26) Polysilizium aufweist.

3. Optischer Empfänger nach Anspruch 1 oder 2, **dadurch gekennzeichnet, dass** die Subtrahiereinheit (30) einen Operationsverstärker aufweist, an dessen invertierenden Eingang die beiden Photodioden (10, 24) antiparallel verschaltet sind.

4. Optischer Empfänger nach Anspruch 3, **dadurch gekennzeichnet, dass** die zweite Photodiode (24) mit ihrer Kathode und die erste Photodiode (10) mit ihrer Anode mit dem invertierenden Eingang des Operationsverstärkers verbunden ist.

5. Optischer Empfänger nach Anspruch 1 bis 4, **dadurch gekennzeichnet, dass** die erste Photodiode (10) ein mit Ladungsträgern eines ersten Leitungstyps dotiertes Halbleitersubstrat (12) mit einem aktiven Gebiet (16), das mit Ladungsträgern eines zweiten Leitungstyps dotiert ist und das an einer Raumladungszone angrenzende erste Gebiet der ersten Photodiode (10) bildet, und in dem aktiven Gebiet (16) ein mit Ladungsträgern des ersten Typs dotiertes Gebiet (24) aufweist, das das an die Raumladungszone angrenzende zweite Gebiet der ersten Photodiode (10) bildet.

6. Optischer Empfänger nach Anspruch 5, **dadurch gekennzeichnet, dass** die aktiven Gebiete (16) für beide Photodioden (10, 24) in einem gemeinsamen Halbleitersubstrat (12) ausgebildet sind.
